# DEMANDE DE BREVET EUROPEEN

(11) **EP 2 322 689 A1**
(43) Date de publication de la demande: **18.05.2011**
(21) Numéro de dépôt: 10447031.5
(22) Date de dépôt: 10.11.2010
(51) Int. Cl.: C23C 14/34, H01J 37/34, C23C 4/12, C23C 4/08, B22D 11/00, B22D 19/08

(54) **Procédé et dispositif pour la fabrication d'une cible de pulvérisation cathodique magnétron**

(30) Priorité: 12.11.2009 BE 200900697
(71) Demandeur: Clavareau, Guy, 5370 Havelange (BE)
(72) Inventeur: Clavareau, Guy, 5370 Havelange (BE)
(74) Mandataire: Cauchie, Daniel

(57) **Abrégé**

L'invention concerne un procédé pour la fabrication d'une cible tubulaire de pulvérisation cathodique ou pour la recharge d'une telle cible usagée ainsi qu'un dispositif pour sa mise en oeuvre.

Selon l'invention, on fait progresser, dans le volume délimité par une paroi de moulage maintenue verticalement et la face extérieure d'un tube (2) support maintenu verticalement ou d'une cible tubulaire (2) à recharger maintenue verticalement, un dépôt de matière en fusion générée par une source d'alimentation et ce, par déplacement soit de cette source d'alimentation, le tube support ou la cible à recharger étant immobile, soit du tube support ou de la cible à recharger, la source d'alimentation étant immobile, pour obtenir un revêtement de matière que l'on refroidit à partir d'une source de refroidissement intérieure ou extérieure au tube support ou à la cible à recharger.

## Description

La présente invention se rapporte, d'une manière générale, à un procédé pour la fabrication d'une cible de pulvérisation cathodique magnétron ou pour la recharge d'une telle cible après usage.

Plus précisément, l'invention concerne un procédé pour la fabrication d'une cible tubulaire de pulvérisation cathodique magnétron ou pour la recharge d'une telle cible après usage et ce, par moulage en continu au départ d'une source de matière en fusion pour pulvérisation cathodique représentée par un métal ou un alliage métallique, cette cible étant formée d'un tube support cylindrique ou d'une cible tubulaire de pulvérisation cathodique magnétron à recharger formée d'un tube recouvert d'une couche usagée de ladite matière pour pulvérisation cathodique.

On connaît déjà des procédés permettant la fabrication en continu de cibles pour la pulvérisation cathodique magnétron.

Ainsi, on peut citer la demande de brevet EP 1186682 qui rapporte la fabrication d'une cible tubulaire pour pulvérisation cathodique magnétron comprenant un moule formé d'un tube support creux cylindrique et, située de manière concentrique, une paroi cylindrique de moulage. Le matériau constituant la cible est fondu, introduit dans le moule et refroidi jusqu'à solidification par un dispositif de refroidissement inséré à l'intérieur du tube support creux.

De même, on peut mentionner le brevet EP 1216772 qui décrit la fabrication d'une cible tubulaire pour pulvérisation cathodique par moulage c'est-à-dire en coulant un matériau en fusion entre un tube support et un tube concentrique chauffé de diamètre plus important que celui du tube de base et en refroidissant cette coulée à partir de l'intérieur du tube de base.

D'autre part, on a rapporté dans le brevet US 5988262 la fabrication d'une cible de pulvérisation en alliage d'aluminium par mise en oeuvre d'un procédé de moulage en continu. Ce procédé nécessite un dispositif comprenant un moule refroidi lequel est muni d'une tige à laquelle est attachée une amorce de l'alliage qui sera utilisé pour la fabrication de la cible. Par traction continue sur la tige et introduction de l'alliage fondu dans le moule, la cible, par exemple sous forme de tube, peut être produite.

En outre, on a décrit dans la demande de brevet W02006/002063 la fabrication d'une cible en cuivre par moulage en continu à partir d'un dispositif dans lequel du cuivre fondu est introduit par une buse dans un moule refroidi pour former une coquille qui est extraite par l'arrière de ce moule. Un système de propulsion d'eau ou d'air peut être prévu en aval du moule pour refroidir la coulée se solidifiant.

Toutefois, aucun des procédés cités précédemment n'est adapté pour recharger en métal ou en alliage une cible usagée caractérisée par des zones d'érosion marquées à certains endroits rendant de telles cibles impropres à la poursuite d'une utilisation.

La présente invention a pour but de proposer un procédé du type indiqué précédemment capable de pallier ces inconvénients en ce qu'il permet notamment de recharger des cibles tubulaires usagées et ainsi de reconstituer une cible de pulvérisation cathodique magnétron prête à l'emploi.

Pour atteindre ce but, le procédé selon l'invention est **caractérisé en ce que**:
a) l'on fait progresser, dans le volume délimité par une paroi de moulage maintenue verticalement et la face extérieure du tube support maintenu verticalement ou de la cible tubulaire à recharger maintenue verticalement, un dépôt d'une quantité appropriée de ladite matière en fusion pour pulvérisation cathodique générée par la source d'alimentation et ce:
   - soit par déplacement de cette source d'alimentation le long du tube support ou de la cible tubulaire à recharger, ce tube support ou cette cible tubulaire à recharger étant maintenu immobile,
   - soit par déplacement du tube support ou de la cible tubulaire à recharger et ce, le long de la source d'alimentation, celle-ci étant maintenue immobile,
   de manière à former un recouvrement de matière de pulvérisation cathodique, et
b) immédiatement après le dépôt, on procède au refroidissement de ce recouvrement de matière de pulvérisation cathodique à partir d'une source de refroidissement intérieure ou extérieure au tube support ou à la cible tubulaire à recharger, de manière à solidifier la matière pour pulvérisation cathodique.

Ainsi, le procédé de l'invention peut être mis en oeuvre en réalisant une progression d'un dépôt de matière en fusion directement sur le tube support ou sur la cible tubulaire à recharger selon une technique de moulage. Cette progression peut être réalisée sur la longueur totale du tube support ou de la cible tubulaire à recharger ou, si nécessaire, sur une fraction de cette longueur. Ce tube support est généralement un tube en métal ou en alliage métallique habituellement un tube en acier inoxydable, la matière destinée au dépôt en question présentant un point de fusion inférieur à celui de la matière constitutive de ce tube support. Toutefois, dans le cas d'une cible tubulaire à recharger, la matière à déposer correspond à celle qui recouvre déjà le tube intérieur de ladite cible et qui présente des zones d'érosion suite à l'utilisation de cette cible pour la réalisation de pulvérisations cathodiques magnétron.

Cette matière à déposer, sur le tube support ou sur la cible tubulaire à recharger, correspond habituellement à un métal à bas point de fusion, par exemple le zinc ou l'étain ou à un alliage métallique de tout métal à bas point de fusion par exemple un alliage de zinc tel qu'un alliage Zn/Al ou Zn/Sn.

La progression du dépôt de matière en fusion peut être réalisée en maintenant immobile, durant cette progression, le tube support ou la cible tubulaire à recharger et en déplaçant, en regard de ce tube support ou de cette cible tubulaire à recharger, un ou plusieurs points d'alimentation en matière en fusion.

Selon une autre mise en oeuvre de cette progression du dépôt, un ou plusieurs points d'alimentation en matière en fusion sont maintenus immobiles durant la progression en question tandis que le tube support ou la cible tubulaire à recharger sont déplacés en regard de ce ou ces points d'alimentation.

En tout état de cause, cette progression de matière en fusion sera réalisée généralement par déversement ou débordement de celle-ci provenant de la source d'alimentation et ce, dans le volume délimité par la paroi de moulage et le tube support ou la cible tubulaire à recharger. Cette progression, par conséquent cette alimentation en matière en fusion, est réalisée avantageusement à vitesse et température contrôlées, le tube support ou la cible tubulaire à recharger étant maintenu verticalement.

Par ailleurs, de manière à réaliser un dépôt d'homogénéité maximale, la matière en fusion subit avantageusement une décantation ainsi qu'un léger brassage avant dépôt sur le tube support ou la cible tubulaire à recharger, la décantation ayant pour effet d' éliminer les turbulences internes produites lors de la fusion ainsi que les bulles d'air éventuellement incluses lesquelles peuvent être responsables de la formation d'occlusions d'oxydes néfastes à la bonne qualité de la cible finale.

Quant au refroidissement, celui-ci est réalisé par l'intermédiaire d'un fluide circulant tel que l'air ou de préférence l'eau ou de tout autre fluide thermo-absorbant provenant d'une source intérieure au tube support ou à la cible tubulaire à recharger ou, de préférence, provenant d'une source extérieure au tube support ou à la cible tubulaire à recharger. Ce refroidissement sera contrôlé de façon à être rapide et constant sur toute la longueur du tube support ou de la cible tubulaire à recharger de manière à éviter toute turbulence susceptible de créer, au sein du revêtement, des bulles d'air préjudiciables à la bonne qualité de celui-ci. En outre, plus le refroidissement sera rapide et plus les particules métalliques de la matière déposée formées au cours de ce refroidissement seront fines (monocristaux) et par conséquent de grande qualité.

Pour la mise en oeuvre du procédé selon l'invention, on peut faire appel, selon l'invention, à un dispositif du type comprenant essentiellement:
- une unité de matière en fusion laquelle comprend une première chambre dite "chambre de fusion" apte à y réaliser la fusion de la matière pour pulvérisation cathodique à déposer sur le tube support ou sur la cible tubulaire à recharger, cette chambre comportant une entrée et une sortie et une seconde chambre dite "chambre d'alimentation" apte à assurer une alimentation en matière en fusion prête pour dépôt sur le tube support ou sur la cible tubulaire à recharger, cette chambre comportant une entrée, une sortie et un orifice d'alimentation,
- une unité de refroidissement de la matière en fusion déposée sur le tube support ou sur la cible tubulaire à recharger, et
- des moyens aptes à assurer le déplacement de l'unité de matière en fusion le long du tube support ou de la cible tubulaire à recharger ou, inversement, le déplacement du tube support ou de la cible tubulaire à recharger le long de l'unité de matière en fusion, un tel moyen pouvant équivaloir par exemple à un moteur électrique,
ce dispositif étant **caractérisé en ce que** l'unité de matière en fusion comprend, en outre, une paroi de moulage sous forme tubulaire, cette paroi de moulage étant ouverte à ses deux extrémités l'une d'elles se situant au niveau de l'orifice d'alimentation de la chambre d'alimentation en particulier l'extrémité supérieure.

Dans le contexte de la présente invention, on désignera par "extrémité inférieure" ou par "extrémité supérieure", l'extrémité d'une partie ou élément constitutif du dispositif selon l'invention qui est respectivement la plus proche ou la plus éloignée d'un plan de référence constitué généralement par le plan sur lequel repose ce dispositif.

La sortie de la chambre de fusion est munie généralement d'un système d'ouverture/fermeture par exemple une vanne apte à permettre le passage contrôlé de la matière en fusion tandis que la sortie de la chambre d'alimentation constitue en fait un orifice d'alimentation ou déversoir apte à permettre la sortie de la matière en fusion par déversement ou débordement. De préférence, cet orifice d'alimentation est muni d'une plaquette de déversement, qui s'étend vers l'extérieur de la chambre d'alimentation, avec pour effet de centrer la coulée de matière en fusion dans le volume délimité par le tube de moulage et le tube support ou la cible tubulaire à recharger.

Avantageusement, l'unité de matière en fusion comprend, en outre, une chambre intermédiaire dite «chambre de décantation» apte à permettre la décantation de la matière en fusion et également apte à assurer un léger brassage de manière à éliminer les turbulences internes produites lors de la fusion ainsi que les bulles d'air éventuellement incluses, cette chambre comportant une entrée et une sortie.

Généralement, l'entrée de cette chambre de décantation est située à la sortie de la chambre de fusion tandis que la sortie de cette même chambre de décantation communique, par l'intermédiaire d'un orifice, avec l'entrée de la chambre d'alimentation.

D'autre part, l'unité de matière en fusion est munie, habituellement d'une ou, généralement, de plusieurs sondes de température présentes par exemple au niveau de la chambre de fusion et de la chambre d'alimentation. De manière à maintenir constante la température choisie de la matière en fusion avant son utilisation pour le moulage, les chambres de décantation et d'alimentation sont habituellement en contact extérieur avec un système de chauffage.

En tout état de cause, tous les éléments constitutifs du dispositif selon l'invention qui seront en contact avec la matière en fusion seront protégées de l'air pour éviter toute oxydation et ce, par mise en oeuvre, soit d'un dispositif mécanique, soit d'un dispositif chimique faisant appel par exemple à des anti-oxydants ou à des gaz neutres.

Tel que mentionné précédemment, l'unité de matière en fusion est pourvue d'une paroi de moulage. Celle-ci se présente sous une forme tubulaire dont l'axe longitudinal est identique à celui du tube support ou de la cible à recharger.

Ce tube de moulage présente un diamètre supérieur à celui du tube support ou de la cible tubulaire à recharger de manière à permettre une coulée de matière en fusion entre d'une part ce tube de moulage et d'autre part ce tube support ou cette cible tubulaire à recharger. Comme l'épaisseur du revêtement à appliquer via cette coulée peut varier d'un tube support ou d'une cible tubulaire à recharger à l'autre, telle que par exemple une épaisseur de 6, 9, 12 ou 15mm, le tube de moulage sera conçu amovible de manière à prévoir son remplacement en fonction des besoins.

Selon une mise en oeuvre particulièrement avantageuse du dispositif selon l'invention, le tube de moulage peut comporter, située au niveau de sa partie supérieure, une portion tubulaire de diamètre différent. Habituellement le diamètre de cette portion du tube de moulage est plus grand que le diamètre de la portion au niveau de sa partie inférieure, ce diamètre restant généralement constant quel que soit le diamètre de cette portion tubulaire inférieure. Par conséquent, le tube de moulage peut éventuellement prendre la configuration d'un cylindre se déformant en forme d'entonnoir. Une telle forme en entonnoir est particulièrement intéressante pour la réalisation d'un revêtement par coulée lorsque l'épaisseur de ce revêtement est relativement faible.

Avantageusement, ce tube de moulage comporte différents accessoires tels que des moyens de détermination et/ou de régulation de la température de coulée de la matière en fusion

En général, le tube de moulage en question est fabriqué en cuivre, de préférence en cuivre exempt d'oxygène ("CuOf"). Toutefois, pour éviter toute formation d'amalgame ou d'alliage avec la matière constitutive du revêtement à poser sur le tube support ou sur la cible tubulaire à recharger, ce tube de moulage sera avantageusement recouvert intérieurement d'une couche d'un matériau protecteur, par exemple une couche de chrome. D'autre part, cette couche présentera une face extérieure particulièrement lisse de manière à favoriser la coulée continue de la matière en fusion et son tassement entre la paroi de moulage et le tube support ou la cible tubulaire à recharger. En outre, ce tube de moulage est solidarisé à l'unité de matière en fusion, au niveau de la chambre d'alimentation, par tout système de fixation approprié par exemple par boulonnage.

Selon une mise en oeuvre particulière, ce tube de moulage est relié à la chambre d'alimentation par l'intermédiaire d'un conduit muni éventuellement d'un système de chauffage.

Quant à l'unité de refroidissement, celle-ci est avantageusement située à l'intérieur ou de préférence à l'extérieur du tube support ou de la cible tubulaire à recharger et comprend un ou plusieurs anneaux, reliés ou non entre eux, parcourus par une circulation d'un fluide de refroidissement soit liquide de préférence l'eau ou tout autre liquide thermo-absorbant soit gazeux de préférence l'air. Ce refroidisseur, qui est généralement indépendant de l'unité de matière en fusion et qui peut éventuellement être muni de chicanes intérieures aptes à augmenter les échanges calorifiques, sera choisi en sorte de pouvoir assurer un refroidissement rapide et contrôlé de la matière en fusion déposée sur le tube support ou la cible tubulaire à recharger.

Le dispositif ainsi conçu comporte en outre des moyens aptes à:
a) maintenir, dans la chambre de fusion, un volume de matière en fusion qui conservera l'ensemble de ses qualités durant le temps nécessaire à la réalisation de revêtements par coulée ou déversement, de ce volume de matière, sur différents tubes support ou différentes cibles tubulaires à recharger. A titre d'exemple, le dispositif selon l'invention pourra comprendre un système de brassage devant assurer une homogénéité constante de la matière en fusion sur le tube support ou sur la cible tubulaire à recharger.
b) déterminer la quantité très précise de matière en fusion à déposer sur le tube support ou la cible tubulaire à recharger, tels que par exemple une vanne, et ce, avec une bonne tolérance.
c) effectuer un montage rapide de l'ensemble formé par l'unité de matière en fusion autour du tube de moulage,
d) réaliser un préchauffage du tube support ou de la cible tubulaire à recharger.

En outre, cette unité de matière en fusion sera dotée d'un système d'isolation thermique de manière à assurer le rendement énergétique optimal.

Selon un mode de réalisation préféré, le dispositif selon l'invention comprend des moyens aptes à assurer son déplacement vertical le long du tube support ou de la cible tubulaire à recharger.

L'invention sera mieux comprise et d'autres buts, caractéristiques et avantages de celle-ci apparaîtront plus clairement au cours de la description explicative qui va suivre faite en référence aux dessins annexés donnés uniquement à titre d'exemple illustrant un mode de réalisation de l'invention et dans lesquels la Figure est une vue partielle d'une coupe frontale schématique du dispositif selon l'invention sectionné longitudinalement par l'axe de symétrie X-X.

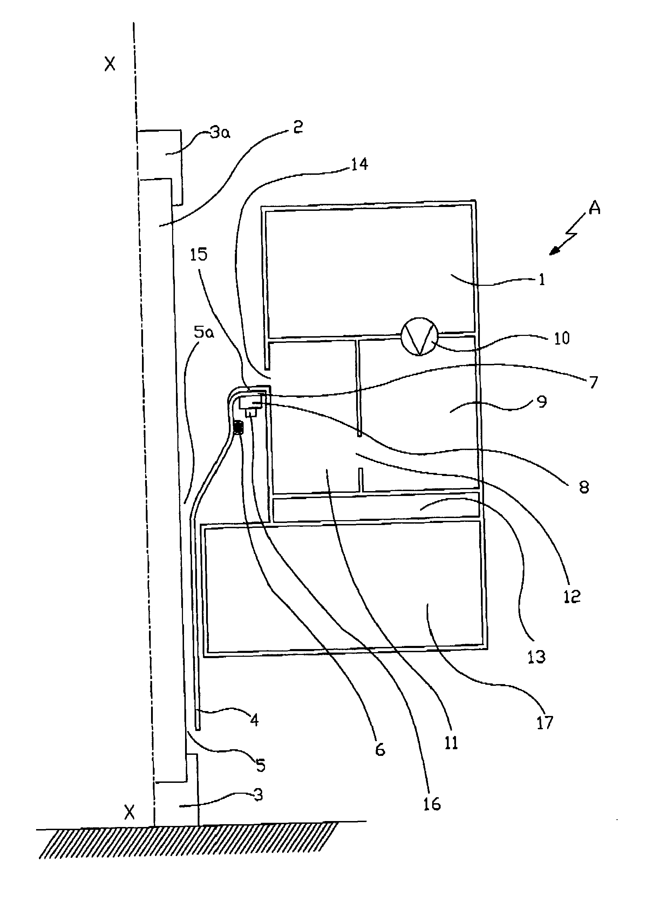

Tel que représenté à la figure 1, le dispositif A selon l'invention comprend une chambre 1 capable d'assurer au moyen d'un système de chauffage (non représenté), par exemple un chauffage électrique, la fusion, jusqu'à liquéfaction, de lingots du métal ou de l'alliage qui constituera le recouvrement extérieur du tube 2 support ou de la cible tubulaire 2 à recharger. Ce tube support ou cette cible tubulaire à recharger, est maintenu verticalement dans des encoches circulaires pratiquées dans des blocs support soit respectivement 3 et 3a à la Figure 1. D'autre part ce tube support ou cette cible tubulaire à recharger, est disposé à l'intérieur d'une gaine 4 configurée en entonnoir laquelle forme la paroi de moulage. Celle-ci est ouverte à son extrémité inférieure 5 et à son extrémité supérieure 5a et comporte une bobine 6 destinée à réguler la température de coulée de la matière en fusion. D'autre part, on observe que cette paroi 4 de moulage s'évase à sa partie supérieure en un rebord 7. De manière à consolider ce rebord, il est prévu une couronne 8 de renfort par exemple en acier inoxydable. D'autre part, on observe une chambre 9 pour la décantation de la matière en fusion et pour un léger brassage, cette chambre étant en relation avec la chambre 1 de fusion via une vanne 10. Cette chambre 9 de décantation est elle-même en communication avec une chambre 11 d'alimentation par l'intermédiaire d'une ouverture 12 pratiquée dans la paroi les séparant. Par ailleurs la chambre de décantation et la chambre d'alimentation sont en contact direct avec un système de chauffage 13 destiné à maintenir constante la température de la matière en fusion présente dans ces deux chambres. La Figure montre, en outre, que la chambre 11 d'alimentation est elle-même munie d'un orifice 14 débouchant sur une couronne support 15 provenant d'une extension de la paroi extérieure de cette chambre 11 d'alimentation et située à la base de cet orifice. Cette couronne support 15 est solidarisée à l'ensemble formé par le rebord 7 de la paroi de moulage et la couronne 8 de renfort par un système 16 de boulons/écrous. Par ailleurs, la Figure montre la présence d'un refroidisseur 17 situé à l'arrière de la chambre d'alimentation 11 lequel comporte une entrée et une sortie (non représentées). L'ensemble ainsi conçu sera, en outre, muni à son extrémité supérieure d'une unité (non représentée) de préchauffage du tube support ou de la cible tubulaire à recharger afin que celui-ci ou celle-ci se présente à bonne température pour recevoir la matière en fusion sur sa paroi extérieure.

Les Exemples non limitatifs suivants illustrent la fabrication d'une cible à partir d'un tube support ou d'une cible tubulaire à recharger.

### EXEMPLE 1

### Le tube support ou la cible tubulaire à recharger est immobile et le dispositif A est mobile

On utilise à cet effet un tube 2 support ou une cible tubulaire 2 à recharger dont les caractéristiques de départ sont les suivantes:
Longueur: 3852 mm
Diamètre: 133 mm
Epaisseur du revêtement en matière pour pulvérisation cathodique à appliquer: 6mm

On boulonne d'abord, à la chambre d'alimentation 11, par l'intermédiaire de sa couronne support 15, une gaine 4 de moulage appropriée c'est-à-dire une gaine dont la paroi intérieure destinée au moulage se situera à une distance de 6mm de la paroi extérieure d'un tube 2 support ou d'une cible tubulaire 2 à recharger. On dispose alors verticalement ce tube support ou cette cible tubulaire à recharger, qui présente les caractéristiques précédentes. Par déplacement vertical du dispositif A, par exemple par le biais d'un moteur électrique, on amène alors l'orifice d'alimentation 14 au niveau du bloc support 3.

Au moyen d'une unité de chauffage électrique (non représentée), on assure ensuite la fusion d'une quantité appropriée de métal sous forme de lingots, par exemple Zn ou d'alliage, par exemple Zn/Al ou Zn/Sn, de manière à obtenir environ 27 litres de ce métal ou de cet alliage liquéfié, la vanne 10 étant fermée. Dès que la fusion est réalisée, on ouvre cette vanne pour permettre l'accès de la matière en fusion à la chambre 9 de décantation chauffée au préalable et on laisse cette matière en fusion s'écouler lentement en vue d'y assurer son homogénéisation par disparition des turbulences produites lors de la fusion et des bulles d'air incorporées pour son léger brassage. Par l'orifice 12, cette matière en fusion est alors amenée dans la chambre 11 d'alimentation. La bouche d'alimentation 14 se trouvant au départ du processus au niveau du bloc support 3, par conséquent au niveau de l'extrémité inférieure du tube support ou de la cible tubulaire à recharger, le trop plein de matière en fusion est alors amené à s'écouler, par gravité et en continu, dans le volume de moulage (largeur: 6mm dans cet exemple) délimité d'une part par le tube 2 support ou la cible tubulaire 2 à recharger et d'autre part par la paroi 4 de moulage. Simultanément, le refroidisseur 17, qui est enclenché, assurera un refroidissement immédiat et contrôlé de la matière en fusion par l'intermédiaire d'une circulation d'eau maintenue en permanence dans ce refroidisseur. Le déversement de matière en fusion est lui-même contrôlé avec précision par un dispositif automatique (non représenté) capable d'arrêter cet apport en cas de nécessité. Au fur et à mesure du remplissage du volume de moulage en question, le dispositif A, mis en mouvement par l'intermédiaire par exemple d'un moteur électrique (non représenté), s'élève le long du tube 2 support ou de la cible tubulaire 2 à recharger. A cet effet, la vitesse d'élévation est calculée en permanence en fonction du taux de remplissage du volume de moulage de manière à éviter des solutions de continuité dans le moulage. Dès que le dispositif A a parcouru la longueur totale du tube support ou de la cible tubulaire à recharger, celui-ci s'arrête au niveau du bloc 3a c'est-à-dire au niveau de l'extrémité supérieure du tube 2 support ou de la cible tubulaire 2 à recharger et ce, sous l'impulsion de systèmes mettant en oeuvre par exemple des capteurs de pression ou des cellules photoélectriques Le démoulage est alors entrepris par dégagement du tube 2 support chargé ou de la cible 2 rechargée hors des encoches des blocs 3 et 3a.

### EXEMPLE 2

### Le tube support ou la cible tubulaire à recharger est mobile et le dispositif A est immobile

On utilise à cet effet un tube 2 support ou une cible tubulaire 2 à recharger dont les caractéristiques sont analogues à celles révélées à l'Exemple 1 et on met en oeuvre un dispositif selon l'invention semblable à celui qui est décrit à ce même Exemple 1 avec toutefois les modifications suivantes:
a) en début de fabrication, le bloc support 3 du tube support ou de la cible tubulaire à recharger est amené en regard de l'orifice d'alimentation 14,
b) au fur et à mesure du remplissage du volume de moulage, le tube support ou la cible tubulaire à recharger est mis en mouvement par l'intermédiaire par exemple d'un moteur électrique de sorte que ce tube support ou cette cible tubulaire à recharger s'abaisse le long de la bouche d'alimentation 14,
c) dès que le tube support ou la cible tubulaire à recharger a parcouru sa longueur totale, celui-ci s'arrête au niveau du bloc 3a.

Le procédé selon l'invention s'est révélé particulièrement intéressant et performant en ce qu'il permet d'obtenir un revêtement de matière, destinée à la pulvérisation cathodique magnétron, sous forme de grains fins et avec une densité de 100% de la densité nominale de la matière sur toute la longueur du tube support ou de la cible initiale à recharger.

De surcroît, le dispositif pour la mise en oeuvre du procédé selon l'invention présente plusieurs avantages notamment un faible encombrement au sol et une grande flexibilité en raison de la maîtrise des paramètres de coulée. En outre, il offre une grande simplicité de maintenance et est doté d'une bonne adaptabilité aux substrats à déposer sur le tube support ou la cible tubulaire à recharger, ce qui laisse envisager le développement de nouveaux revêtements sur de tels tubes support ou cibles tubulaires à recharger.

## Revendications

1. Procédé pour la fabrication d'une cible tubulaire de pulvérisation cathodique magnétron ou pour la recharge d'une telle cible après usage et ce, par moulage en continu au départ d'une source de matière en fusion pour pulvérisation cathodique représentée par un métal ou un alliage métallique, cette cible étant formée d'un tube support cylindrique ou d'une cible tubulaire de pulvérisation cathodique magnétron à recharger formée d'un tube recouvert d'une couche usagée de matière pour pulvérisation cathodique, **caractérisé en ce que**:
a) l'on fait progresser, dans le volume délimité par une paroi de moulage maintenue verticalement et la face extérieure du tube (2) support maintenu verticalement ou de la cible (2) tubulaire à recharger maintenue verticalement, un dépôt d'une quantité appropriée de la dite matière en fusion pour pulvérisation cathodique générée par la source d'alimentation et ce:
- soit par déplacement de cette source d'alimentation le long du tube support ou de la cible tubulaire à recharger, ce tube support ou cette cible tubulaire à recharger étant maintenu immobile,
- soit par déplacement du tube support ou de la cible tubulaire à recharger et ce, le long de la source d'alimentation, celle-ci étant maintenue immobile,
de manière à former un recouvrement de matière de pulvérisation cathodique, et
b) immédiatement après ledit dépôt, on procède au refroidissement de ce recouvrement de matière de pulvérisation cathodique à partir d'une source de refroidissement extérieure au tube support ou à la cible tubulaire à recharger, de manière à solidifier la matière pour pulvérisation cathodique.

2. Procédé selon la revendication 1, **caractérisé en ce qu**'avant dépôt sur le tube support ou la cible tubulaire à recharger, la matière en fusion subit une décantation ainsi qu'un léger brassage, la décantation ayant pour effet d'éliminer les turbulences internes et les bulles d'air éventuellement incluses.

3. Procédé selon la revendication 1 ou 2, **caractérisé en ce que** la progression du dépôt de matière en fusion le long du tube support ou de la cible tubulaire à recharger est réalisée à vitesse et température contrôlées.

4. Procédé selon l'une des revendications 1 à 3, **caractérisé en ce que** l'on réalise, dans ledit volume, la progression du dépôt de matière en fusion par déversement ou débordement de celle-ci provenant de la source d'alimentation.

5. Procédé selon l'une des revendications 1 à 4, **caractérisé en ce que** le fluide de refroidissement est l'eau ou tout autre liquide thermo-absorbant.

6. Dispositif pour la mise en oeuvre du procédé selon l'une des revendications 1 à 5 du type comprenant:
- une unité de matière en fusion qui comprend une première chambre (1) dite chambre de fusion apte à y réaliser la fusion de la matière pour pulvérisation cathodique à déposer sur un tube (2) support ou sur une cible tubulaire (2) à recharger, cette chambre comportant une entrée et une sortie et une seconde chambre (11) dite chambre d'alimentation apte à assurer une alimentation en matière en fusion prête pour dépôt sur le tube support ou sur la cible tubulaire à recharger, cette chambre comportant une entrée, une sortie et un orifice d'alimentation,
- une unité (17) de refroidissement de la matière en fusion déposée sur le tube support ou la cible tubulaire à recharger, et
- des moyens aptes à assurer le déplacement de l'unité de matière en fusion le long du tube support ou de la cible tubulaire à recharger ou, inversement, le déplacement du tube support ou de la cible tubulaire à recharger le long de l'unité de matière en fusion,
**caractérisé en ce que** l'unité de matière en fusion comprend, en outre, une paroi (4) de moulage sous forme tubulaire, cette paroi de moulage étant ouverte à ses deux extrémités (5 ; 5a) l'une d'elles se situant au niveau de l'orifice (14) d'alimentation de la chambre d'alimentation.

7. Dispositif selon la revendication 6, **caractérisé en ce que** l'extrémité de la paroi de moulage se situant au niveau de l'orifice d'alimentation de la chambre d'alimentation est l'extrémité (5a) supérieure.

8. Dispositif selon la revendication 6 ou 7, **caractérisé en ce que** le tube (4) de moulage, dont l'axe longitudinal est identique à celui du tube (2) support ou de la cible tubulaire (2) à recharger, présente un diamètre supérieur à celui de ce tube support ou de cette cible tubulaire à recharger.

9. Dispositif selon l'une des revendications 6 à 8, **caractérisé en ce que** l'unité de matière en fusion comprend, en outre, une chambre intermédiaire (9) comportant une entrée et une sortie dite chambre de décantation, cette chambre intermédiaire étant apte à permettre la décantation de la matière en fusion de manière à éliminer les turbulences internes produites lors de la fusion ainsi que les bulles d'air éventuellement incluses et également apte à assurer un léger brassage.

10. Dispositif selon la revendication 9, **caractérisé en ce que** l'entrée de la chambre (9) de décantation est située à la sortie de la chambre (1) de fusion tandis que la sortie de cette même chambre de décantation communique, par l'intermédiaire d'un orifice (12), avec l'entrée de la chambre (11) d'alimentation.

11. Dispositif selon la revendication 9 ou 10, **caractérisé en ce que** la chambre de décantation et la chambre d'alimentation sont en contact extérieur avec un système de chauffage.

12. Dispositif selon l'une des revendications 6 à 11, **caractérisé en ce qu**'il comprend un système de brassage apte à assurer une homogénéité constante de la matière en fusion sur le tube support ou sur la cible tubulaire à recharger.

13. Dispositif selon l'une des revendications 6 à 12, **caractérisé en ce que** l'unité (17) de refroidissement est située à l'intérieur ou à l'extérieur du tube (2) support ou de la cible tubulaire (2) à recharger et comprend un ou plusieurs anneaux éventuellement reliés entre eux et éventuellement munis de chicanes intérieures aptes à augmenter les échanges calorifiques.

14. Dispositif selon l'une des revendications 6 à 13, **caractérisé en ce qu**'il comporte des moyens aptes à:
a) maintenir, dans la chambre de fusion, un volume de matière en fusion qui conservera l'ensemble de ses qualités durant le temps nécessaire à la réalisation de revêtements par déversement, de ce volume de matière, sur différents tubes support ou différentes cibles tubulaires à recharger,
b) déterminer la quantité très précise de matière en fusion à déposer sur le tube support ou la cible tubulaire à recharger,
c) effectuer un montage rapide de l'ensemble formé par l'unité de matière en fusion autour du tube de moulage,
d) réaliser un préchauffage du tube support ou de la cible tubulaire à recharger.

15. Dispositif selon l'une des revendications 6 à 14, **caractérisé en ce que** l'unité de matière en fusion est dotée d'une isolation thermique.
